# EUROPEAN PATENT APPLICATION

(11) **EP 3 018 486 A1**
(43) Date of publication of application: **11.05.2016**
(21) Application number: 14819796.5
(22) Date of filing: 20.06.2014
(51) Int. Cl.: G01R 31/36, B60L 3/00, B60L 11/18, H01M 10/44, H01M 10/48, H02J 7/00

(54) **VEHICLE STORAGE BATTERY MANAGEMENT DEVICE, VEHICLE POWER UNIT, AND VEHICLE STORAGE BATTERY MANAGEMENT METHOD**

(30) Priority: 03.07.2013 JP 2013140227
(71) Applicant: Panasonic Intellectual Property Management Co., Ltd., Osaka-shi, Osaka 540-6207 (JP)
(72) Inventor: TAGOME, Masaki, Osaka-shi, Osaka 540-6207 (JP); KOBAYASHI, Susumu, Osaka-shi, Osaka 540-6207 (JP); ADACHI, Masakazu, Osaka-shi, Osaka 540-6207 (JP); TANABE, Mitsuru, Osaka-shi, Osaka 540-6207 (JP)
(74) Representative: Appelt, Christian W.
(86) International application number: PCT/JP2014/003319
(87) International publication number: WO 2015/001751

(57) **Abstract**

A vehicle storage battery management device includes a charge level acquiring portion, a power capacity acquiring portion and, a power capacity deriving portion. The charge level acquiring portion acquires data of a charge level, which indicates a ratio of a capacity of a storage battery installed in an electric drive vehicle to a full charge capacity of the storage battery, from the electric drive vehicle. The power capacity acquiring portion acquires data of an amount of charging power supplied to the storage battery or data of an amount of discharging power discharged from the storage battery. The power capacity deriving portion derives a unit capacity of the storage battery based on the amount of charging power or the amount of discharging power, and a change in the charge level that occurs according to the amount of charging power or the amount of discharging power.

## Description

### TECHNICAL FIELD

The invention relates generally to vehicle storage battery management devices, vehicle power units, and vehicle storage battery management methods and, more particularly, to a vehicle storage battery management device, a vehicle power unit, and vehicle storage battery management method, which are configured to acquire data in relation to a storage battery from an electric drive vehicle.

### BACKGROUND ART

Environmentally friendly electric drive vehicles with less toxic exhaust have been recently introduced in markets, thereby diffusing vehicle power units that allow a storage battery of an electric drive vehicle to charge and discharge (For example, see JP 2013-102608 A, JP 2013-81290 A). Examples of an electric drive vehicle include an Electric Vehicle (EV), a Plug-in Hybrid Electric Vehicle (PHEV) and the like. The vehicle power unit is provided with not only a function of charging a storage battery of an electric drive vehicle but also a function of performing electrical discharge from the storage battery of the electric drive vehicle to a household load(s) (V2H) and electrical discharge from the storage battery to a commercial power grid (V2G).

The vehicle power unit performs charging/discharging control of the storage battery installed in the electric drive vehicle by being connected to the electric drive vehicle through a charging/discharging cable, and performing charging/discharging power control. Further not only a power line to be an electric circuit of the charging/discharging power but also a communication line is provided in the charging/discharging cable, and the vehicle power unit acquires data in relation to the storage battery from the electric drive vehicle through the communication line.

The vehicle power unit acquires data in relation to a charging status of the storage battery from the electric drive vehicle. The data in relation to the charging status of the storage battery indicates a ratio (a charge level) of a capacity of the storage battery to a full charge capacity of the storage battery, and is shown as for example "50%", "80%" or the like.

However, an actual charge capacity in the full charge capacity status of the storage battery gradually decreases due to a temporal change of the storage battery. Therefore, even if charge levels of the storage battery respectively acquired by the vehicle power unit within certain periods are same, the actual capacity of the storage battery may be changed.

In such a conventional technology, it is impossible to grasp the actual capacity of the storage battery in the case where the charge level data of the storage battery is acquired from the electric drive vehicle.

### DISCLOSURE OF THE INVENTION

The present invention has been made in view of the above-described circumstances, and an object thereof is to provide a vehicle storage battery management device, a vehicle power unit, and a vehicle storage battery management method which can grasp an actual capacity of the storage battery even data in relation to a charge level of the storage battery acquired from the electric drive vehicle is a ratio of a capacity of the storage battery to a full charge capacity of the storage battery.

A vehicle storage battery management device of the present invention includes: a charge level acquiring portion configured to acquire data of a charge level, which indicates a ratio of a capacity of a storage battery installed in an electric drive vehicle to a full charge capacity of the storage battery, from the electric drive vehicle; a power capacity acquiring portion configured to acquire data of an amount of charging power supplied to the storage battery or data of an amount of discharging power discharged from the storage battery; and a power capacity deriving portion configured to derive a unit capacity, which is a capacity of the storage battery corresponding to a unit amount of the charge level of the storage battery, based on the amount of charging power and a change in the charge level that occurs according to the amount of charging power, or based on the amount of discharging power and a change in the charge level that occurs according to the amount of discharging power, and then derive the capacity of the storage battery based on the unit capacity and the charge level.

A vehicle power unit of the present invention includes a vehicle storage battery management device, and a charging/discharging device. The vehicle storage battery management device includes: a charge level acquiring portion configured to acquire data of a charge level, which indicates a ratio of a capacity of a storage battery installed in an electric drive vehicle to a full charge capacity of the storage battery, from the electric drive vehicle; a power capacity acquiring portion configured to acquire data of an amount of charging power supplied to the storage battery or data of an amount of discharging power discharged from the storage battery; and a power capacity deriving portion configured to derive a unit capacity which is a capacity of the storage battery corresponding to a unit amount of the charge level of the storage battery based on the amount of charging power and a change in the charge level that occurs according to the amount of charging power, or based on the amount of discharging power and a change in the charge level that occurs according to the amount of discharging power, and then derive the capacity of the storage battery based on the unit capacity and the charge level. The charging/discharging device is configured to perform at least a charge control of the storage battery or a discharge control of the storage battery based on the capacity of the storage battery derived by the power capacity deriving portion.

A vehicle storage battery management method of the present invention includes: acquiring data of a charge level, which indicates a ratio of a capacity of a storage battery installed in an electric drive vehicle to a full charge capacity of the storage battery, from the electric drive vehicle; acquiring data of an amount of charging power supplied to the storage battery, or data of an amount of discharging power discharged from the storage battery; and deriving a unit capacity which is a capacity of the storage battery corresponding to a unit amount of the charge level of the storage battery based on the amount of charging power and a change in the charge level that occurs according to the amount of charging power, or based on the amount of discharging power and a change in the charge level that occurs according to the amount of discharging power, and then deriving the capacity of the storage battery based on the unit capacity and the charge level.

### BRIEF DESCRIPTION OF THE DRAWINGS

Fig. 1 is a block diagram showing a configuration of a vehicle power management system of a first embodiment, and
Fig. 2 is a block diagram showing a part of a configuration of a vehicle power management system of a second embodiment.

### DESCRIPTION OF EMBODIMENTS

Embodiments of the present invention will be explained based on the drawings.

### (First embodiment)

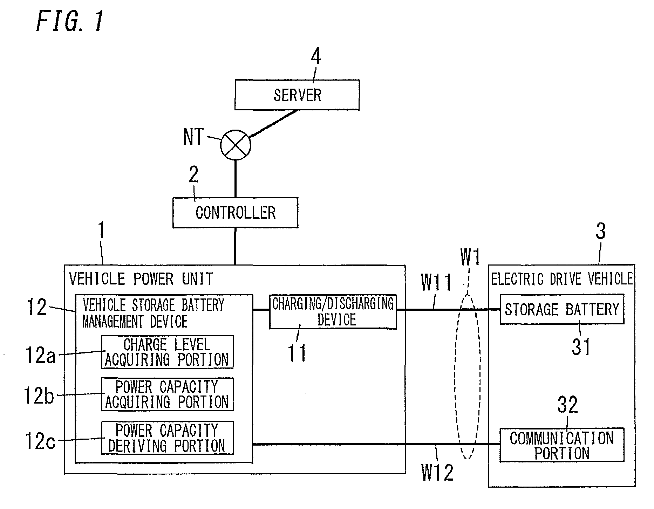

Fig. 1 shows a configuration of a vehicle power management system. The system includes: a vehicle power unit 1 provided at a house, a store, an office or the like, of a user; and a controller 2, as a main configuration.

The vehicle power unit 1 is connected with one end of a charging/discharging cable W1 and the other end of the charging/discharging cable W1 is detachably attached to an electric drive vehicle 3 such as an Electric Vehicle (EV), a Plug-in Hybrid Electric Vehicle (PHEV) or the like. The vehicle power unit 1 includes a charging/discharging device 11 and a vehicle storage battery management device 12 (hereinafter, referred to as a management device 12). The electric drive vehicle 3 includes a storage battery 31 and a communication portion 32. The charging/discharging cable W1 includes a power line W11 and a communication line W12.

Between the charging/discharging device 11 and the storage battery 31, transferring of charging power and discharging power are performed through the power line W11. Between the management device 12 and the communication portion 32, transferring of a signal is performed through the communication line W12.

The charging/discharging device 11 generates DC power (charging power) from a commercial power grid. The charging/discharging device 11 supplies charging power to the storage battery 31 installed in the electric drive vehicle 3 and thereby the storage battery 31 is charged. In addition to a function of charging the storage battery 31 of the electric drive vehicle 3, the charging/discharging device 11 has a function of performing electrical discharge from the storage battery 31 to a household load (not shown) (V2H) and electrical discharge from the storage battery 31 to a commercial power grid (V2G).

The management device 12 includes a charge level acquiring portion 12a, a power capacity acquiring portion 12b, and a power capacity deriving portion 12c, and manages a capacity of the storage battery 31 installed in the electric drive vehicle 3.

The charge level acquiring portion 12a acquires data of a charge level, which is data in relation to the charging status of the storage battery 31, from the electric drive vehicle 3. The charge level acquiring portion 12a transmits a data acquiring request to the electric drive vehicle 3, and the communication portion 32 that has received the data acquiring request generates data of the charge level of the storage battery 31 and transmits to the management device 12. This data of charge level indicates a ratio of a capacity of the storage battery 31 to a full charge capacity of the storage battery 31 (charge level %), and is shown as for example "50%", "80%" or the like.

The power capacity acquiring portion 12b acquires power amount data from the charging/discharging device 11. The power amount data indicates an amount of charging power (Wh) supplied from the charging/discharging device 11 to the storage battery 31 or an amount of discharging power (Wh) discharged from the storage battery 31 by the charging/discharging device 11.

The power capacity deriving portion 12c calculates a unit capacity (Wh/%), based on: the amount of charging power or the amount of discharging power during a predetermined period, depending on the power amount data; and a change in the charge level of the storage battery 31 that occurs according to the amount of charging power or the amount of discharging power. The unit capacity (Wh/%) is a capacity (Wh) of the storage battery 31 corresponding to a unit amount (1%) of the charge level of the storage battery 31.

In detail, the power capacity deriving portion 12c performs a process of deriving the unit capacity regularly (for example, every week, every month or the like).

The charge level acquiring portion 12a acquires a first charge level data from the electric drive vehicle 3 before the charging/discharging device 11 starts a charging sequence or a discharging sequence for the storage battery 31. Then the charge level acquiring portion 12a acquires a second charge level data from the electric drive vehicle 3 after the charging sequence or the discharging sequence for the storage battery 31 by the charging/discharging device 11 is completed.

Further, the power capacity acquiring portion 12b acquires, from the charging/discharging device 11, power amount data indicating the amount of charging power supplied to the storage battery 31 by the charging sequence, or the amount of discharging power discharged from the storage battery 31 by the discharging sequence.

Then the power capacity deriving portion 12c divides the amount of charging power (Wh) supplied to the storage battery 31 or the amount of discharging power (Wh) discharged from the storage battery 31, by a difference between the first charge level and the second charge level (%). In other words, the power capacity deriving portion 12c can derive the capacity (Wh) of the storage battery 31 corresponding to the unit amount (1%) of the charge level of the storage battery 31. The capacity (Wh) of the storage battery 31 corresponding to the unit amount (1%) of the charge level is referred to as a unit capacity (Wh/%).

During the normal operation of the vehicle power unit 1, the charge level acquiring portion 12a acquires data of the charge level from the electric drive vehicle 3. The power capacity deriving portion 12c can acquire an actual capacity (Wh) of the storage battery 31 by multiplying, by a unit capacity, the data of the charge level which the charge level acquiring portion 12a has acquired from the electric drive vehicle 3.

The full charge capacity of the storage battery 31 gradually decreases due to a temporal change of the storage battery 31. That is, even if charge levels of the storage battery 31 respectively acquired by the charge level acquiring portion 12a within certain periods are same, an actual capacity of the storage battery 31 may be changed. However, the management device 12 of the present embodiment calculates a unit capacity regularly and can derive an actual capacity of the storage battery 31 (Wh) from an charge level (%) acquired from the electric drive vehicle 3 by using the unit capacity. Therefore, the management device 12 can grasp the actual capacity of the storage battery 31, even when data in relation to the charge status of the storage battery 31 acquired from the electric drive vehicle 3 is the ratio of a capacity of the storage battery 31 to the full charge capacity of the storage battery 31.

In the normal operation, the charging/discharging device 11 of the vehicle power unit 1 performs charging/discharging control of the storage battery 31 based on the actual capacity (Wh) of the storage battery 31 which the power capacity deriving portion 12c has derived. Therefore, the charging/discharging device 11 can grasp the capacity of the storage battery 31 with high accuracy and thus can improve an accuracy of the charring/discharging control of the storage battery 31.

When performing a process of deriving the capacity unit, it is preferable that the charge level acquiring portion 12a acquire the charge level data from the electric drive vehicle 3 after the electric drive vehicle stopped for a predetermined time period. Here the electric drive vehicle stopped means that an engine of the electric drive vehicle is stopped. The predetermined time period is a time period required to lowering a temperature of the storage battery 31 to an ambient temperature and the time period is set to substantially half a day at most, based on a season and time of a day. From that, it is possible to improve the accuracy of a unit capacity which the power capacity deriving portion 12c derives. Note that, there might be a case where a temperature control function, which adjusts the temperature to be within a predetermined temperature range, is provided at the storage battery 31 for vehicle. In this configuration there are both possibilities: a state where the temperature of the storage battery 31 is higher than the ambient temperature; and a state where the temperature of the storage battery 31 is lower than the ambient temperature, depending on a season, time of a day or the like. In this case, above mentioned predetermined time period is a time period required for the temperature of the storage battery 31 to drop or increase to the ambient temperature.

Also it is preferable that the power capacity deriving portion 12c correct the derived capacity of the storage battery 31 based on the ambient temperature of the electric drive vehicle 3. For example, there is a tendency that as a difference between the ambient temperature and a reference value is larger (i.e., a case of being higher than the reference value or a case of being lower than the reference value), a load on the storage battery 31 further increases, and thus the capacity of the storage battery 31 which the power capacity deriving portion 12c has derived increases. Since that, the power capacity deriving portion 12c corrects the capacity of the storage battery 31 into smaller amount, as the difference between the ambient temperature and the reference value is larger. Therefore, it is possible to improve the accuracy of the actual capacity (Wh) of the storage battery 31, which the power capacity deriving portion 12c derives.

The electric drive vehicle 3 with the storage battery 31 also estimates, therein, a capacity of the storage battery 31 with consideration of decrease in a capacity of the storage battery 31, based on various kinds of parameters during a charging/discharging operation, of the storage battery 31. However, regarding the capacity estimate of the storage battery 31 performed in the electric drive vehicle 3, the charging/discharging operation of the storage battery 31 depends on the traveling state of the electric drive vehicle 3. Therefore, the charging/discharging power of the electric drive vehicle 3 during traveling always fluctuates and thus it is difficult to estimate the capacity with high accuracy.

On the other hand, performing, outside the electric drive vehicle 3, the capacity estimate with consideration of decrease in a capacity of the storage battery 31 is a major point in the present embodiment. For example, the amount of charging power to be controlled by the charging/discharging device 11 can be optionally adjusted by setting an arbitrary charging schedule such as a night time charging where the charging/discharging device 11 charges the storage battery 31 during night time. The amount of discharging power to be controlled by the charging/discharging device 11 can be also optionally adjusted by setting a grid connection control to arbitrary control content. Accordingly, in the present embodiment, it is possible to achieve the charging/discharging operation appropriate to the process of deriving the unit capacity, which is performed by the power capacity deriving portion 12c, by controlling the charging/discharging device 11 without depending on the traveling state of the electric drive vehicle 3, and thus estimate a capacity of the storage battery 31 with high accuracy. That is, it is preferable that the charging/discharging device 11 control at least one of the charging current of the storage battery 31 or the discharging current of the storage battery 31 in accordance to the process of deriving the unit capacity, which is performed by the power capacity deriving portion 12c.

### (Second embodiment)

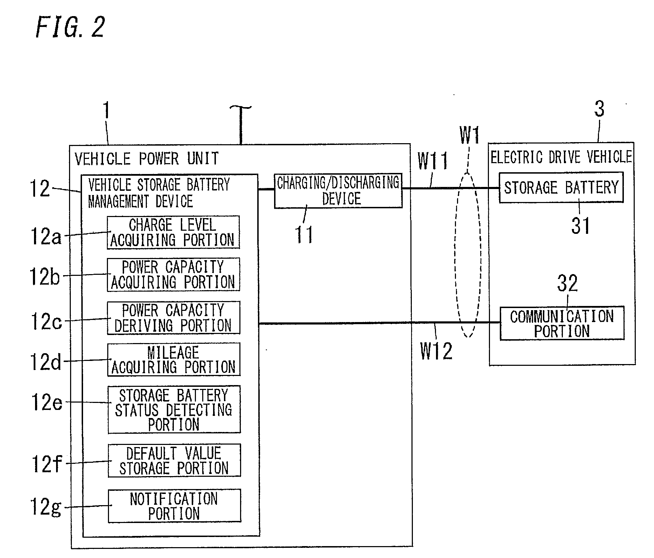

As shown in Fig. 2, a management device 12 of the present embodiment includes a mileage acquiring portion 12d, a storage battery status detecting portion 12e, a default value storage portion 12f, and a notification portion 12g. Note that other components are similar to those of the first embodiment and are assigned with same reference signs, and descriptions thereof will be omitted.

The mileage acquiring portion 12d acquires data of mileage of an electric drive vehicle 3. Here, the data of the mileage of electric drive vehicle 3 indicates an acuminated mileage of the electric drive vehicle 3.

The storage battery status detecting portion 12e detects a status of a storage battery 31, such as a deterioration degree.

In detail, a charge level acquiring portion 12a acquires data of a first charge level of the electric drive vehicle 3, and the mileage acquiring portion 12d acquires data of a first mileage of the electric drive vehicle 3, before a charging/discharging cable W1 is detached from the electric drive vehicle 3 and the electric drive vehicle 3 starts traveling. When the charging/discharging cable W1 is reattached to the electric drive vehicle 3 after the traveling, the charge level acquiring portion 12a acquires data of a second charge level of the electric drive vehicle 3, and the mileage acquiring portion 12d acquires data of a second mileage of the electric drive vehicle 3.

Then the storage battery status detecting portion 12e calculates earned mileage within the traveling this time, by subtracting the first mileage from the second mileage. Further, the storage battery status detecting portion 12e calculates a change in the charge level depending on the traveling this time, by subtracting the second charge level from the first charge level.

The storage battery status detecting portion 12e detects the deterioration degree of the storage battery 31 based on the change in the mileage earned within the traveling this time and the change in the charge level occurred in the traveling this time. For example, the storage battery status detecting portion 12e divides the change (%) in the charge level depending on the traveling this time by the mileage (km) earned in the traveling this time. In other word, the storage battery status detecting portion 12e calculates the charge level of the storage battery 31, which the electric drive vehicle 3 requires for traveling 1 km. The larger a difference between this calculated value (%/km) and a default value of the calculated value is, the greater the deterioration degree of the storage battery 31 is.

Another method that the storage battery status detecting portion 12e detects the deterioration degree of the storage battery 31 is to detect based on a charge level of the storage battery 31 and a capacity of the storage battery 31. In detail, it is a method of employing a unit capacity (Wh/%) and in this case, the smaller a difference between a unit capacity (Wh/%) and a default value of the unit capacity is, the greater the deterioration degree of the storage battery 31 is.

The default value storage portion 21f stores the above mentioned default value of the calculated value (%/km) or the above mentioned default value of the unit capacity (Wh/%). The former default value is a calculated value (%/km) when a new storage battery 31 is used, and the latter default value is a unit capacity (Wh/%) when a new storage battery 31 is used. The default values are values previously determined through tests, simulation or the like.

Alternatively, the former default value may be a calculated value (%/km) which the storage battery status detecting portion 12e has calculated immediately after restoring the storage battery 31, and the latter default value may be a unit capacity (Wh/%) which the power capacity deriving portion 12c has derived immediately after restoring the storage battery 31. In this case, the default value of the calculated value (%/km) or the default value of the unit capacity (Wh/%) may be stored in the default value storage portion 12f through operation by a user.

The storage battery status detecting portion 12e commands the notification portion 12g to notify the user of the deterioration of the storage battery 31 when the deterioration degree of the storage battery 31 has exceeded a predetermined degree. For example, the storage battery status detecting portion 12e determines that a deterioration degree of the storage battery 31 has exceeded the predetermined deterioration degree when the capacity of the storage battery 31 has decreased to around 20 to 30% of a rated capacity.

The notification portion 12g has a sound notification mean using speaker or the like, and a visual notification mean using a liquid crystal display or the like. The sound notification mean outputs, to the user, for example a voice message or an alarm for prompting the user to perform maintenance or changing of the storage battery unit 31, upon receiving the command from the storage battery status detecting portion 12e. Also, the visual notification mean displays for the user a message for prompting the user to perform maintenance or changing of the storage battery unit 31, upon receiving the command from the storage battery status detecting portion 12e.

A charging/discharging device 11 controls charging/discharging of the storage battery 31 according to the deterioration degree of the storage battery 31. For example, the charging/discharging device 11 achieves life prolongation of the storage battery 31 by controlling a charging current and a discharging current such that the greater the deterioration degree of the storage battery 31 is, the longer a charging time and a discharging time are.

Note, the charging/discharging device 11 is not limited to a charging/discharging device that performs both of a charging control of the storage battery 31 and a discharging control of the storage battery 31, but it may be a power converter that has a function of performing at least one of the charging control of the storage battery 31 or the discharging control of the storage battery 31.

Also, as shown in Fig. 1, a controller 2 is connected to a vehicle power unit 1 of each of the above mentioned embodiments. The controller 2 includes a liquid crystal display and an operation portion and the like, which are not shown, and an operation of the vehicle power unit 1 is monitored and controlled through the user's operation. The controller 2 is configured to communicate with a server 4 through a network NT such as the Internet. The server 4 can remotely monitor and control the operation of the vehicle power unit 1 via the controller 2 by having communication with the controller 2.

A management device 12 of each of the above mentioned embodiments may be provided in the controller 2 or the server 4. In this case, the management device 12 provided in the controller 2 or the server 4 transfers each kind of data with the vehicle power unit 1 and the electric drive vehicle 3, and accordingly, the above mentioned similar effect can be obtained.

A notification portion (not shown) may be provided in the controller 2. In this case, when the deterioration degree of the storage battery 31 has exceeded the predetermined degree, the storage battery status detecting portion 12e commands the controller 2 to output, with sound or display, the voice message or the alarm for prompting the user to perform maintenance or change of the storage battery unit 31.

As explained, the vehicle storage battery management device 12 includes: a charge level acquiring portion 12a configured to acquire data of the charge level, which indicates a ratio of the capacity of the storage battery 31 installed in the electric drive vehicle 3 to a full charge capacity of the storage battery 31, from the electric drive vehicle3. The vehicle storage battery management device 12 further includes a power capacity acquiring portion 12b configured to acquire data of an amount of charging power supplied to the storage battery 31 or data of an amount of discharging power discharged from the storage battery 31. Furthermore, the vehicle storage battery management device 12 includes a power capacity deriving portion 12c. The power capacity deriving portion 12c is configured to derive a unit capacity, which is a capacity of the storage battery 31 corresponding to the unit amount of the charge level of the storage battery 31, based on the amount of charging power and a change in the charge level that occurs according to the amount of charging power, or the power capacity deriving portion 12c is configured to derive a unit capacity, which is a capacity of the storage battery 31 corresponding to the unit amount of the charge level of the storage battery 31, based on the amount of discharging power and the change in the charge level that occurs according to the amount of discharging power. The power capacity deriving portion 12c is configured to derive the capacity of the storage battery 31 based on the unit capacity and the charge level.

According to this configuration, the vehicle storage battery management device 12 derives an actual capacity of the storage battery 31 from data of the charge level acquired from the electric drive vehicle 3. Therefore, the vehicle storage battery management device 12 can grasp an actual capacity of the storage battery 31, even when data in relation to the charging status of the storage battery 31, acquired from the electric drive vehicle 3, is a ratio of a capacity of the storage battery 31 to the full charge capacity of the storage battery 31.

Here, it is preferable that the vehicle storage battery management device 12 include the storage battery status detecting portion 12e configured to detect a status of the storage battery 31.

According to this configuration, the vehicle storage battery management device 12 can detect a status of the storage battery 31.

The vehicle storage battery management device 12 further includes the mileage acquiring portion 12d configured to acquire data of a mileage of the electric drive vehicle 3 from the electric drive vehicle 3. It is preferable that the storage battery status detecting portion 12e be configured to detect the status of the storage battery 31 based on the mileage and a change in the charge level occurred within the mileage.

According to this configuration, the vehicle storage battery management device 12 can detect the status of the storage battery 31 based on the mileage and the change in the charge level.

It is preferable that the storage battery status detecting portion 12e be configured to detect the status of the storage battery 31 based on the charge level of the storage battery 31 and the capacity of the storage battery 31.

According to this configuration, the vehicle storage battery management device 12 can detect the status of the storage battery 31 based on the charge level of the storage battery 31 and the capacity of the storage battery 31.

It is preferable that the status of the storage battery 31 be the deterioration degree of the storage battery 31, and the storage battery status detecting portion 12e be configured to command the notification portion 12g to notify the user of the deterioration of the storage battery 31 when the deterioration degree of the storage battery 31 has exceeded the predetermined degree.

According to this configuration, the vehicle storage battery management device 12 notifies the user, when the deterioration degree of the storage battery 31 has exceeded the predetermined degree, and thus the user can know the deterioration degree.

It is preferable that the charge level acquiring portion 12a be configured so that when deriving the unit capacity, the charge level acquiring portion 12a acquires the data of the charge level from the electric drive vehicle 3 after the electric drive vehicle 3 stopped for a predetermined time period.

According to the configuration, the vehicle storage battery management device 12 can improve an accuracy of the unit capacity which the power capacity deriving portion 12c derives.

It is preferable that the power capacity deriving portion 12c be configured to correct the capacity of the storage battery 31 based on an ambient temperature of the electric drive vehicle 3.

According to the configuration, the vehicle storage battery management device 12 can improve an accuracy of an actual capacity of the storage battery 31 which the power capacity deriving portion 12c derives.

The vehicle power unit 1 includes the vehicle storage battery management device 12 and the charging/discharging device 11. The vehicle storage battery management device 12 includes the charge level acquiring portion 12a configured to acquire data of the charge level, which indicates a ratio of a capacity of the storage battery 31 installed in the electric drive vehicle 3 to the full charge capacity of the storage battery 31, from the electric drive vehicle 3. Further, the vehicle storage battery management device 12 includes the power capacity acquiring portion 12b configured to acquire data of an amount of charging power supplied to the storage battery 31 or data of an amount of discharging power discharged from the storage battery 31. Furthermore, the vehicle storage battery management device 12 includes the power capacity deriving portion 12c. The power capacity deriving portion 12c is configured to derive a unit capacity which is a capacity of the storage battery 31 corresponding to a unit amount of a charge level of the storage battery 31, based on the amount of charging power and the change in the charge level that occurs according to the amount of charging power, or based on the amount of discharging power and the change in the charge level that occurs according to the amount of discharging power. The power capacity deriving portion 12c is configured to derive the capacity of the storage battery 31 based on the unit capacity and the charge level. The charging/discharging device 11 is configured to perform at least the charge control of the storage battery 31 or the discharge control of the storage battery 31 based on the capacity of the storage battery 31 derived by the power capacity deriving portion 12c.

According to this configuration, the vehicle power unit 1 derives an actual capacity of the storage battery 31 form the data of charge level acquired from the electric drive vehicle 3. Therefore, the vehicle power unit 1 can grasp the actual capacity of the storage battery 31, even when data in relation to the charge status of the storage battery 31 acquired from the electric drive vehicle 3 is a ratio of a capacity of the storage battery 31 to the full charge capacity of the storage battery 31.

Here, it is preferable that the vehicle storage battery management device 12 further include the storage battery status detecting portion 12e configured to detect a status of the storage battery 31, and the charging/discharging device 11 be configured to control at least the charging current of the storage battery 31, or the discharging current of the storage battery 31 according to the status of the storage battery 31.

According to this configuration, the vehicle power unit 1 can control at least the charging current of the storage battery 31, or the discharging current of the storage battery 31 according to the status of the storage battery 31.

It is preferable that the charging/discharging device 11 be configured to control at least the charging current of the storage battery 31 or the discharging current of the storage battery 31 according to a deriving process of the capacity unit by the power capacity deriving portion 12c.

According to this configuration, the vehicle power unit 1 can control at least the charging current of the storage battery 31 or the discharging current of the storage battery 31 according to the deriving process of the capacity unit by the power capacity deriving portion 12c.

A vehicle storage battery management method includes acquiring data of the charge level, which indicates a ratio of the capacity of the storage battery 31 installed in the electric drive vehicle 3 to the full charge capacity of the storage battery 31, from the electric drive vehicle 3. Further, the vehicle storage battery management method includes acquiring data of an amount of charging power supplied to the storage battery 31, or data of an amount of discharging power discharged from the storage battery 31. Furthermore, the vehicle storage battery management method includes deriving a unit capacity which is a capacity of the storage battery 31 corresponding to a unit amount of the charge level of the storage battery 31 based on the amount of charging power and a change in the charge level that occurs according to the amount of charging power, or based on the amount of discharging power and a change in the charge level that occurs according to the amount of discharging power, and then deriving the capacity of the storage battery 31 based on the unit capacity and the charge level..

Accordingly, the vehicle storage battery management method derives an actual capacity of the storage battery 31 from data of charge level acquired from the electric drive vehicle 3. Therefore, by the vehicle storage battery management method, it is possible to grasp the actual capacity of the storage battery 31 even when data in relation to the charge status of the storage battery 31 acquired from the electric drive vehicle 3 is a ratio of a capacity of the storage battery 31 to the full charge capacity of the storage battery 31.

## Claims

1. A vehicle storage battery management device comprising:
a charge level acquiring portion configured to acquire data of a charge level, which indicates a ratio of a capacity of a storage battery installed in an electric drive vehicle to a full charge capacity of the storage battery, from the electric drive vehicle;
a power capacity acquiring portion configured to acquire data of an amount of charging power supplied to the storage battery or data of an amount of discharging power discharged from the storage battery; and
a power capacity deriving portion configured to derive a unit capacity, which is a capacity of the storage battery corresponding to a unit amount of the charge level of the storage battery, based on the amount of charging power and a change in the charge level that occurs according to the amount of charging power, or based on the amount of discharging power and a change in the charge level that occurs according to the amount of discharging power, and then derive the capacity of the storage battery based on the unit capacity and the charge level.

2. The vehicle storage battery management device of claim 1 further comprising a storage battery status detecting portion configured to detect a status of the storage battery.

3. The vehicle storage battery management device of claim 2 further comprising a mileage acquiring portion configured to acquire data of a mileage of the electric drive vehicle from the electric drive vehicle;
wherein the storage battery status detecting portion is configured to detect the status of the storage battery based on the mileage and a change in the charge level occurred within the mileage.

4. The vehicle storage battery management device of claim 2 wherein the storage battery status detecting portion is configured to detect the status of the storage battery based on the charge level of the storage battery and the capacity of the storage battery.

5. The vehicle storage battery management device of any one of claims 2 to 4 wherein,
the status of the storage battery is a deterioration degree of the storage battery, and
the storage battery status detecting portion is configured to command a notification portion to notify a user of a deterioration of the storage battery when the deterioration degree of the storage battery has exceeded a predetermined degree.

6. The vehicle storage battery management device of any one of claims 1 to 5 wherein the charge level acquiring portion is configured so that when deriving the unit capacity, the charge level acquiring portion acquires the data of the charge level from the electric drive vehicle after the electric drive vehicle stopped for a predetermined time period.

7. The vehicle storage battery management device of any one of claims 1 to 6 wherein the power capacity deriving portion is configured to correct the capacity of the storage battery based on an ambient temperature of the electric drive vehicle.

8. A vehicle power unit comprising:
a vehicle storage battery management device including a charge level acquiring portion configured to acquire data of a charge level, which indicates a ratio of a capacity of a storage battery installed in an electric drive vehicle to a full charge capacity of the storage battery, from the electric drive vehicle, a power capacity acquiring portion configured to acquire data of an amount of charging power supplied to the storage battery or data of an amount of discharging power discharged from the storage battery, and a power capacity deriving portion configured to derive a unit capacity which is a capacity of the storage battery corresponding to a unit amount of the charge level of the storage battery based on the amount of charging power and a change in the charge level that occurs according to the amount of charging power, or based on the amount of discharging power and a change in the charge level that occurs according to the amount of discharging power, and then derive the capacity of the storage battery based on the unit capacity and the charge level; and
a charging/discharging device configured to perform at least a charge control of the storage battery or a discharge control of the storage battery based on the capacity of the storage battery derived by the power capacity deriving portion.

9. The vehicle power unit of claim 8 wherein the vehicle storage battery management device further includes a storage battery status detecting portion configured to detect a status of the storage battery,
wherein the charging/discharging device is configured to control at least a charging current of the storage battery or a discharging current of the storage battery according to the status of the storage battery.

10. The vehicle power unit of claim 8 or 9 wherein the charging/discharging device is configured to control at least a charging current of the storage battery or a discharging current of the storage battery according to a deriving process of the capacity unit by the power capacity deriving portion.

11. A vehicle storage battery management method comprising:
acquiring data of a charge level, which indicates a ratio of a capacity of a storage battery installed in an electric drive vehicle to a full charge capacity of the storage battery, from the electric drive vehicle;
acquiring data of an amount of charging power supplied to the storage battery, or data of an amount of discharging power discharged from the storage battery; and
deriving a unit capacity which is a capacity of the storage battery corresponding to a unit amount of the charge level of the storage battery based on the amount of charging power and a change in the charge level that occurs according to the amount of charging power, or based on the amount of discharging power and a change in the charge level that occurs according to the amount of discharging power, and then deriving the capacity of the storage battery based on the unit capacity and the charge level.

## Amended claims

### Amended claims under Art. 19.1 PCT

**1.** (Amended) A vehicle storage battery management device comprising:
a charge level acquiring portion configured to acquire data of a charge level, which indicates a ratio of a capacity of a storage battery installed in an electric drive vehicle to a full charge capacity of the storage battery, from the electric drive vehicle;
a power capacity acquiring portion configured to acquire data of an amount of charging power supplied to the storage battery or data of an amount of discharging power discharged from the storage battery; and
a power capacity deriving portion configured to derive a unit capacity, which is a capacity of the storage battery corresponding to a unit amount of the charge level of the storage battery, based on the amount of charging power and a change in the charge level that occurs according to the amount of charging power, or based on the amount of discharging power and a change in the charge level that occurs according to the amount of discharging power, and then derive the capacity of the storage battery based on the unit capacity and the charge level,
the power capacity deriving portion being configured to correct the capacity of the storage battery into smaller amount, as an absolute value of a difference between an ambient temperature of the electric drive vehicle and a reference value is larger.

**2.** The vehicle storage battery management device of claim 1 further comprising a storage battery status detecting portion configured to detect a status of the storage battery.

**3.** The vehicle storage battery management device of claim 2 further comprising a mileage acquiring portion configured to acquire data of a mileage of the electric drive vehicle from the electric drive vehicle;
wherein the storage battery status detecting portion is configured to detect the status of the storage battery based on the mileage and a change in the charge level occurred within the mileage.

**4.** The vehicle storage battery management device of claim 2 wherein the storage battery status detecting portion is configured to detect the status of the storage battery based on the charge level of the storage battery and the capacity of the storage battery.

**5.** The vehicle storage battery management device of any one of claims 2 to 4 wherein,
the status of the storage battery is a deterioration degree of the storage battery, and
the storage battery status detecting portion is configured to command a notification portion to notify a user of a deterioration of the storage battery when the deterioration degree of the storage battery has exceeded a predetermined degree.

**6.** The vehicle storage battery management device of any one of claims 1 to 5 wherein the charge level acquiring portion is configured so that when deriving the unit capacity, the charge level acquiring portion acquires the data of the charge level from the electric drive vehicle after the electric drive vehicle stopped for a predetermined time period.

**7.** Deleted)

**8.** (Amended) A vehicle power unit comprising:
a vehicle storage battery management device including a charge level acquiring portion configured to acquire data of a charge level, which indicates a ratio of a capacity of a storage battery installed in an electric drive vehicle to a full charge capacity of the storage battery, from the electric drive vehicle, a power capacity acquiring portion configured to acquire data of an amount of charging power supplied to the storage battery or data of an amount of discharging power discharged from the storage battery, and a power capacity deriving portion configured to derive a unit capacity which is a capacity of the storage battery corresponding to a unit amount of the charge level of the storage battery based on the amount of charging power and a change in the charge level that occurs according to the amount of charging power, or based on the amount of discharging power and a change in the charge level that occurs according to the amount of discharging power, and then derive the capacity of the storage battery based on the unit capacity and the charge level; and
a charging/discharging device configured to perform at least a charge control of the storage battery or a discharge control of the storage battery based on the capacity of the storage battery derived by the power capacity deriving portion,
the power capacity deriving portion being configured to correct the capacity of the storage battery into smaller amount, as an absolute value of a difference between an ambient temperature of the electric drive vehicle and a reference value is larger.

**9.** The vehicle power unit of claim 8 wherein the vehicle storage battery management device further includes a storage battery status detecting portion configured to detect a status of the storage battery,
wherein the charging/discharging device is configured to control at least a charging current of the storage battery or a discharging current of the storage battery according to the status of the storage battery.

**10.** (Amended) The vehicle power unit of claim 8 or 9 wherein the charging/discharging device is configured to control at least a charging current of the storage battery or a discharging current of the storage battery according to a result derived in a deriving process of the capacity unit by the power capacity deriving portion.

**11.** (Amended) A vehicle storage battery management method comprising:
acquiring data of a charge level, which indicates a ratio of a capacity of a storage battery installed in an electric drive vehicle to a full charge capacity of the storage battery, from the electric drive vehicle;
acquiring data of an amount of charging power supplied to the storage battery, or data of an amount of discharging power discharged from the storage battery; and
deriving a unit capacity which is a capacity of the storage battery corresponding to a unit amount of the charge level of the storage battery based on the amount of charging power and a change in the charge level that occurs according to the amount of charging power, or based on the amount of discharging power and a change in the charge level that occurs according to the amount of discharging power, and then deriving the capacity of the storage battery based on the unit capacity and the charge level, and further correcting the capacity of the storage battery into smaller amount, as an absolute value of a difference between an ambient temperature of the electric drive vehicle and a reference value is larger.
